# EUROPEAN PATENT APPLICATION

(11) **EP 1 951 014 A2**
(43) Date of publication of application: **30.07.2008**
(21) Application number: 08001055.6
(22) Date of filing: 21.01.2008
(51) Int. Cl.: H05K 3/36

(54) **Junction structure of flexible substrate**

(30) Priority: 26.01.2007 JP 2007016622
(71) Applicant: Olympus Corporation, Tokyo 151-0072 (JP)
(72) Inventor: Tanaka, Yoshinori, Hachioji-shi Tokyo 192-8512 (JP); Hatakeyama, Tomoyuki, Hachioji-shi Tokyo 192-8512 (JP)
(74) Representative: Winter, Brandl, Fürniss, Hübner Röss, Kaiser, Polte Partnerschaft Patent- und Rechtsanwaltskanzlei

(57) **Abstract**

A junction structure of a flexible substrate includes a flexible substrate (1) provided with junction terminals (2). An opposing substrate (5) is placed opposite to the flexible substrate, and provided with junction terminals (6) corresponding to the junction terminals (2). A thermosetting resin adhesive (8) is interposed between the flexible substrate (1) and opposing substrate (5), and used to join the flexible substrate (1) and opposing substrate (5). A thermal conduction equalizing member (3) is formed in at least one of the flexible substrate (1) and opposing substrate (5), independently of the junction terminals (2) formed in the flexible substrate (1) and the junction terminals (6) formed in the opposing substrate (5), not to make an electrical connection between the flexible substrate (1) and opposing substrate (5).

## Description

The present invention relates to a junction structure of a flexible substrate.

Concerning the joining of two or more substrates, Jpn. Pat. Appln. KOKAI Publication No. 2003-152019 discloses a structure which connects a first substrate with more than two electrode terminals having at least two different widths, narrow and wide, to a second substrate. The width of each electrode terminal formed in a second substrate is substantially the same as the width of the narrow electrode in the first substrate. By connecting two or more electrode terminals of a second substrate to the wide electrode terminal in a first substrate, the widths and intervals of the electrode terminals are made uniform, and a shift amount of anisotropic conductive resin interposed between the first and second substrates is made equal. This prevents generation of bubbles caused by unequal amount of the anisotropic conductive resin, and provides a reliable connection structure.

In the technique disclosed in the above Application No. 2003-152019, transmission of heat may be different in the electrode terminals and space portions formed between the electrode terminals. If a temperature is suddenly increased in this state, a temperature difference increases in the electrode terminals and space portions. Thus, as a temperature increases, the anisotropic conductive resin before hardening shifts to the electrode terminals. As a result, the anisotropic conductive resin is hardened in the state no resin remains in the space portions, generating bubbles.

It is an object of the invention to provide a junction structure of a flexible substrate, which prevents generation of bubbles even if a high temperature is suddenly applied when connecting substrates, and permits joining while maintaining peel strength and connection resistance.

According to a first aspect of the invention there is provided a junction structure of a flexible substrate comprising: a flexible substrate (1) provided with junction terminals (2); an opposing substrate (5) which is placed opposite to the flexible substrate, and provided with junction terminals (6) corresponding to the junction terminals (2); a thermosetting resin adhesive (8) which is interposed between the flexible substrate (1) and opposing substrate (5), and used to join the flexible substrate (1) and opposing substrate (5); and a thermal conduction equalizing member (3) which is formed in at least one of the flexible substrate (1) and opposing substrate (5), independently of the junction terminals (2) formed in the flexible substrate (1) and the junction terminals (6) formed in the opposing substrate (5), not to make an electrical connection between the flexible substrate (1) and opposing substrate (5).

The invention can be more fully understood from the following detailed description when taken in conjunction with the accompanying drawings, in which:
FIG. 1 is a sectional view of a junction structure of a flexible substrate according to a first embodiment of the invention, in the state before substrates are joined;
FIG. 2A is a plan view of a flexible substrate in a flexible substrate junction structure according to a first embodiment of the invention;
FIG. 2B is a plan view of an opposing substrate in a flexible substrate junction structure according to a first embodiment of the invention;
FIG. 3 is a sectional view of a junction structure of a flexible substrate according to a first embodiment of the invention, in the state that substrates are joined;
FIG. 4 is a sectional view of a junction structure of a flexible substrate in a modification of a first embodiment of the invention, in the state before substrates are joined;
FIG. 5 a sectional view of a junction structure of a flexible substrate in a modification of a first embodiment of the invention, in the state that substrates are joined;
FIG. 6 is a sectional view of a junction structure of a flexible substrate according to a second embodiment of the invention, in the state before substrates are joined; and
FIG. 7 is a sectional view of a flexible substrate in a flexible substrate junction structure according to a second embodiment of the invention, in the state that substrates are joined.

Hereinafter, the embodiments of the invention will be explained with reference to the accompanying drawings.

### [Embodiment 1]

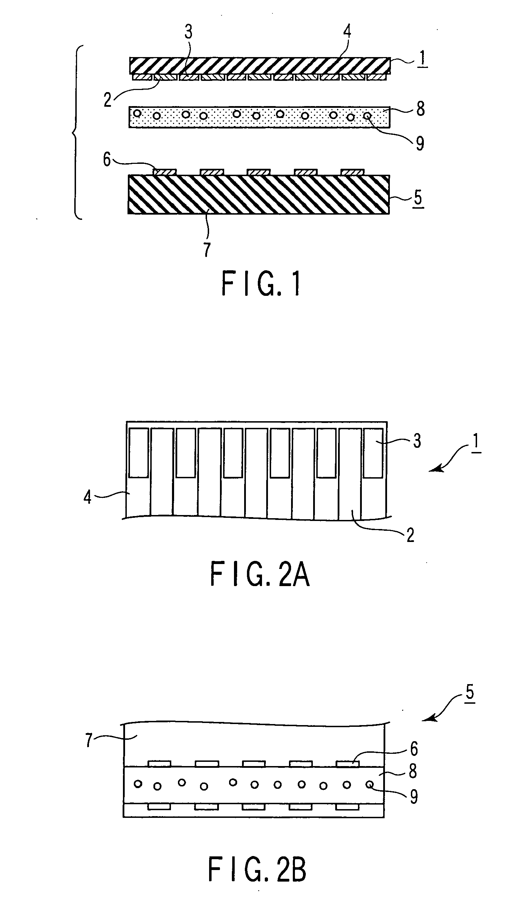

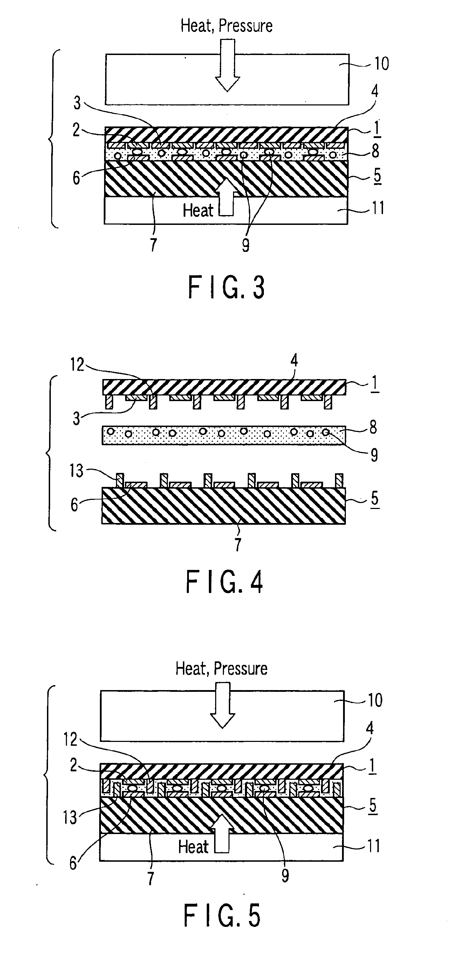

First, a first embodiment of the invention will be explained with reference to FIGS. 1 to 3. FIG. 1 is a sectional view of a junction structure of a flexible substrate according to a first embodiment of the invention, in the state before substrates are joined. FIG. 2A is a plan view of a flexible substrate in a flexible substrate junction structure according to a first embodiment. FIG. 2B is a plan view of an opposing substrate in a flexible substrate junction structure according to a first embodiment of the invention. FIG. 3 is a sectional view of a junction structure of a flexible substrate according to a first embodiment of the invention, in the state that substrates are joined.

In the junction structure of a flexible substrate according to a first embodiment, a junction member is interposed between a flexible substrate and a substrate (hereinafter, called an opposing substrate) placed opposite to the flexible substrate. In this structure, the flexible substrate and opposing substrate are electrically connected, and joined together while maintaining mechanical strength.

As shown in FIGS. 1 and 2A, a flexible substrate 1 is provided with two or more conductive junction terminals 2 made of copper, for example, with a predetermined interval. In space portions formed between the junction terminals 2, thermal conduction equalizing members 3 are formed. Each of the thermal conduction equalizing members 3 is arranged not to make an electrical contact with the junction terminal 2, and provided as a dummy member not to make an electrical connection between the flexible substrate 1 and opposing substrate 5.

The thermal conduction equalizing members 3 are made of materials with thermal conductivity higher than a base material 4 of the flexible substrate 1. For example, if the base material 4 of the flexile substrate 1 is made of polyimide, as thermal conductivity of polyimide is about 0.2 W/(m·K), the thermal conduction equalizing members 3 are to be made of materials with thermal conductivity higher than 0.2 W/(m·K). The thermal conduction equalizing members 3 may be made of the same copper as the junction terminals 2, for example. As thermal conductivity of copper is about 400 W/(m·K), the above condition is satisfied. The junction terminals 2 and thermal conduction equalizing members 3 are not necessarily made of the same material, but it is necessary to use a substantially same material from the viewpoint of thermal conductivity.

Each of the thermal conduction equalizing members 3 has the width lower than an interval between the junction terminals 2. Therefore, the thermal conduction equalizing members 3 do not come in contact with the junction terminals 2. Each of the thermal conduction equalizing members 3 has the thickness lower than the total thickness of one of the junction terminals 2 of the flexible substrate 1 and one of the junction terminals 6 of the opposing substrate 5. Therefore, the flexible substrate 1 and opposing substrate 5 are not made conductive by the thermal conduction equalizing members 3.

As each of the junction terminals 2 of the flexible substrate 1, a gold-plated copper wire, a nickel-gold plated copper wire, a solder-plated copper wire, or a tin-plated copper wire is considerable in addition to a copper wire.

As shown in FIGS. 1 and 2B, the opposing substrate 5 is provided with the junction terminals 6 that are electrically joined to the junction terminals 2 of the flexible substrate 1. A base material 7 of the opposing substrate 5 is made of any one of polyimide, epoxy, lead zirconate titanate, glass and silicon. The opposing substrate 5 may be either a flexible substrate or a printed wiring board. Elements mounted on the opposing substrate 5 are not particularly limited, and may be any of a piezoelectric element used in an ultrasonic transducer, a liquid crystal display, an integrated circuit and micro-electromechanical system (MEMS). Each of the junction terminals 6 may be a copper wire, gold-plated copper wire, nickel-gold plated copper wire, tin-plated copper wire, silver palladium electrode, indium tin oxide (ITO), aluminum wire, and gold wire.

A junction member joins the flexible substrate 1 to the opposing substrate 5, and may be anisotropic conductive paste (ACP), anisotropic conductive film (ACF) and non-conductive paste (NCP). FIG. 1 shows the case that anisotropic conductive paste or anisotropic conductive film is used for a junction member. Anisotropic conductive paste or anisotropic conductive film is made by mixing conductive particles 9 into a thermosetting resin adhesive 8. The thermosetting resin adhesive 8 is heated in the state that electrical conductivity is ensured by inserting collapsed conductive particles 9 between the junction terminals 2 of the flexible substrate 1 and the junction terminals 6 of the opposing substrate. Therefore, the thermosetting resin adhesive 8 is hardened, and the flexible substrate 1 is joined to the opposing substrate 5 while maintaining mechanical strength.

When NCP is used for a junction member, thermosetting NCP is applied between the junction surface of the flexible substrate 1 and the junction surface of the opposing substrate 5, and NCP is hardened in the state that the junction terminals 6 of the opposing substrate 5 and the junction terminals 2 of the flexible substrate 1 are being directly stuck together, thereby joining the substrates.

Next, an explanation will be given on a method of joining the flexible substrate 1 and opposing substrate 5 with reference to FIG. 3.
(1) First, provide a junction member on the opposing substrate 5, as shown in FIG. 3.
(2) Fix the opposing substrate 5 to a stage 11.
(3) Align and fix the junction terminals 2 of the flexible substrate 1 and the junction terminals 6 of the opposing substrate 5.
(4) Heat a joining tool 10 while pressing to the upper surface of the flexible substrate 1, as shown in FIG. 3. Harden the junction member, and heat and crimp the flexible substrate 1 to the opposing substrate 5. At the same time of heating the joining tool 10, it is preferable to heat the stage 11 at the same temperature as the joining tool 10.
(5) Lastly, release the joining tool 10, and complete the joining of the flexible substrate 1 and opposing substrate 5.

Next, an explanation will be given on the function of the first embodiment. As shown on FIG. 3, when joining the junction terminals 2 of the flexible substrate 1 to the junction terminals 6 of the opposing substrate 5 by heating and pressing the joining tool 10, the same heat applied to the junction terminals 2 are applied to the thermal conduction equalizing members 3 formed in the space portions other than the junction terminals 2. Thus, conduction of heat becomes substantial same in the junction terminals 2 and the space portions formed between junction terminals 2, and there is no temperature difference between the junction terminals 2 and the space portions. Therefore, a shift of the thermosetting resin adhesive 8 forming the junction member is controlled, and the thermosetting resin adhesive 8 remains in the space portions, preventing generation of bubbles.

As explained above, according to the first embodiment, generation of bubbles caused by thermal conductivity difference between the junction terminals 2 and the space portions formed between junction terminals 2 can be prevented. Therefore, peel strength upon joining can be held high, and connection resistance can be held low. This improves the reliability of joining.

Further, when the flexible substrate 1 is joined to opposing substrate 5, heat is applied from both flexible substrate 1 and opposing substrate 5, so that the temperatures of the joining tool 10 and stage 11 become the same. Therefore, comparing with heating from only one side, a temperature difference between the junction terminals 2 and the space portions formed between junction terminals 2 is reduced, and the substrates can be joined at the same temperature.

The thermal conduction equalizing members 3 are formed on the same plane as the junction terminals 2 of the flexible substrate 1. Therefore, when the flexible substrate 1 is joined to opposing substrate 5, space portions formed between the flexible substrate 1 and opposing substrate 5 become small by the extent forming the thermal conductivity equalizing members 3. This reduces the amount of the thermosetting resin adhesive 8 upon joining, and reduces the manufacturing costs.

Further, as the junction terminals 2 and thermal conduction equalizing members 3 are made of the same material, when the flexible substrate 1 is manufactured, the junction terminals 2 and thermal conduction equalizing members 3 can be made of the same material. This reduces the manufacturing costs.

As the width of each of the thermal conduction equalizing members 3 is smaller than the interval between the junction terminals 2, the thermal conduction equalizing members 3 do not come in contact with the junction terminals 2. This ensures the insulation between the junction terminals 2, and minimizes occurrence of a short circuit, even if the junction terminals 2 or thermal conduction equalizing members 3 are displaced.

The thickness of each of the thermal conduction equalizing members 3 is smaller than the total thickness of one of the junction terminals 2 of the flexible substrate 1 and one of the junction terminals 6 of the opposing substrate 5. Therefore, when a load is imposed on the flexible substrate 1 by the joining tool 10, the load is not applied to the thermal conduction equalizing members 3, but the load is applied to the junction terminals 2 of the flexible substrate 1 and the junction terminals 6 of the opposing substrate 5. The substrates can be joined by a sufficient load even if the load is small, and as a result an increase in connection resistance is prevented.

Further, by increasing thermal conductivity of each of the thermal conduction equalizing members 3 to higher than that of the base material of the flexible substrate 1, when the flexible substrate 1 is heated from the upper side, the heat is conducted to the thermal conduction equalizing members 3 faster than the flexible substrate 1. Therefore, the heating time can be reduced.

In the first embodiment, the thermal conduction equalizing members 3 may be formed in space portions formed between the junction terminals 6 of the opposing substrate 5.

### [Modification]

Modification of the first embodiment will be explained with reference to FIGS. 4 and 5. FIG. 4 is a sectional view of a junction structure of a flexible substrate in a modification of the first embodiment of the invention, in the state before the substrates are joined. FIG. 5 is a sectional view of a junction structure of a flexible substrate in the modification, in the state that the substrates are joined. In the modification, the parts similar to those used in the first embodiment are given the same reference numbers, and explanation on these parts will be omitted.

As in the first embodiment, a junction member is interposed between a flexible substrate and an opposing substrate in a junction structure of a flexible substrate in this modification, whereby the flexible substrate and opposing substrate are electrically connected, and joined together while maintaining mechanical strength.

In the modification, the flexible substrate 1 is provided with columnar thermal conduction equalizing members 12, as shown in FIG. 4. The opposing substrate 5 is provided with columnar thermal conductivity equalizing members 13. The thermal conduction equalizing members 12 of the flexible substrate 1 and the thermal conductivity equalizing members 13 of the opposing substrate 5 are formed at different positions, as shown in FIG. 5, so that the sides of these members are adjoined when the substrates are joined together.

The method of joining the flexible substrate 1 to the opposing substrate 5 is the same as in the first embodiment.

In such a modification, generation of bubbles is prevented by the same effect as in the first embodiment, when the flexible substrate 1 is heated as shown in FIG. 5 upon joining. In addition, by forming the thermal conduction equalizing members 12 of the flexible substrate 1 and the thermal conduction equalizing members 13 of the opposing substrate 5 at different positions so that the sides of the substrates are adjoined, the junction surface area of the thermosetting resin adhesive 8 is increased, and the junction strength is increased.

### [Embodiment 2]

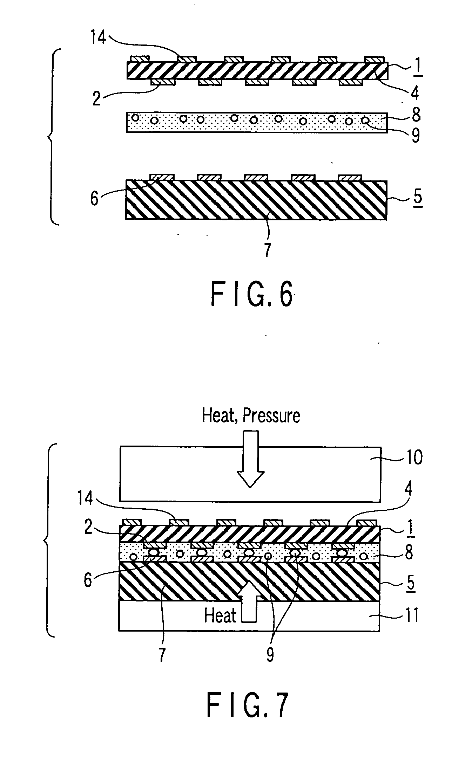

A second embodiment of the invention will be explained with reference to FIGS. 6 and 7. FIG. 6 is a sectional view of a junction structure of a flexible substrate according to a second embodiment of the invention, in the state before the substrates are joined. FIG. 7 is a sectional view of a flexible substrate in the flexible substrate junction structure according to a second embodiment, in the state that the substrates are joined. In the second embodiment, the parts similar to those used in the first embodiment are given the same reference numbers, and explanation on these parts will be omitted.

As in the first embodiment, a junction member is interposed between a flexible substrate and an opposing substrate in a junction structure of a flexible substrate in a second embodiment, whereby the flexible substrate and opposing substrate are electrically connected, and joined together while maintaining mechanical strength.

In the second embodiment, the junction terminals 2 are formed on the surface of the flexible substrate 1 opposite to the opposing substrate 5, as shown in FIG. 6. A thermal conduction equalizing members 14 are formed at positions on the backside of the flexible substrate 1 corresponding to space portions formed between the junction terminals 2.

In FIG. 6, the thermal conduction equalizing members 14 are formed on the backside of the flexible substrate 1, but the positions are not limited to the backside. For example, when the thermal conduction equalizing members 14 are formed in the opposing substrate 5, it can be formed on the side of the opposing substrate 5.

The method of joining the flexible substrate 1 to the opposing substrate 5 is the same as in the first embodiment.

According to the second embodiment having such a configuration, generation of bubbles is prevented by the same effect as in the first embodiment, when the flexible substrate 1 is heated as shown in FIG. 7 upon joining. In addition, by forming the junction terminals 2 and thermal conduction equalizing members 14 on different planes of the flexible substrate 1, insulation of the thermal conduction equalizing members 14 to the junction terminals 2 is ensured, and insulation between junction terminals can be kept compared with the structure that the junction terminals 2 and thermal conduction equalizing members 14 are formed on the same plane as explained in the first embodiment and modification.

## Claims

1. A junction structure of a flexible substrate **characterized by** comprising:
a flexible substrate (1) provided with junction terminals (2);
an opposing substrate (5) which is placed opposite to the flexible substrate, and provided with junction terminals (6) corresponding to the junction terminals (2);
a thermosetting resin adhesive (8) which is interposed between the flexible substrate (1) and opposing substrate (5), and used to join the flexible substrate (1) and opposing substrate (5); and
a thermal conduction equalizing member (3) which is formed in at least one of the flexible substrate (1) and opposing substrate (5), independently of the junction terminals (2) formed in the flexible substrate (1) and the junction terminals (6) formed in the opposing substrate (5), not to make an electrical connection between the flexible substrate (1) and opposing substrate (5).

2. The junction structure of the flexible substrate according to claim 1, **characterized in that** the thermal conduction equalizing member (3) is formed on the same plane as the junction terminals (2) formed in the flexible substrate (1) or the junction terminals (6) formed in the opposing substrate (5).

3. The junction structure of the flexible substrate according to claim 2, **characterized in that** the thermal conduction equalizing member (3) is made of the same material as the junction terminals (2) formed in the flexible substrate (1) or the junction terminals (6) formed in the opposing substrate (5).

4. The junction structure of the flexible substrate according to claim 3, **characterized in that** the total thickness of one of the junction terminals (2) formed in the flexible substrate (1) and one of the junction terminals (6) formed in the opposing substrate (5) is thicker than the thickness of the thermal conduction equalizing member (3).

5. The junction structure of the flexible substrate according to claim 4, **characterized in that** the thermal conduction equalizing member (3) has the width narrower than an interval between the junction terminals (2) formed in the flexible substrate (1) or an interval between the junction terminals (6) formed in the opposing substrate (5).

6. The junction structure of the flexible substrate according to claim 5, **characterized in that** the thermal conduction equaling member is formed in the flexible substrate (1) and opposing substrate (5), and
the thermal conduction equalizing member (12) of the flexible substrate (1) and the thermal conduction equalizing member (13) of the opposing substrate are formed at different positions so that the sides of the members are adjoined.

7. The junction structure of the flexible substrate according to claim 5, **characterized in that** the thermal conduction member (3) is made of the same material as the junction terminals (2) formed in the flexible substrate (1) or the junction terminals (6) formed in the opposing substrate (5).

8. The junction structure of the flexible substrate according to claim 3, **characterized in that** the thermal conduction equalizing member (3) has the width narrower than an interval between the junction terminals (2) formed in the flexible substrate (1) or an interval between the junction terminals (6) formed in the opposing substrate (5).

9. The junction structure of the flexible substrate according to claim 8, **characterized in that** the thermal conduction equaling member is formed in the flexible substrate (1) and opposing substrate (5), and
the thermal conduction equalizing member (12) of the flexible substrate (1) and the thermal conduction equalizing member (13) of the opposing substrate are formed at different positions so that the sides of the members are adjoined.

10. The junction structure of the flexible substrate according to claim 8, **characterized in that** the thermal conduction member (3) is made of the same material as the junction terminals (2) formed in the flexible substrate (1) or the junction terminals (6) formed in the opposing substrate (5).

11. The junction structure of the flexible substrate according to claim 1, **characterized in that** the thermal conduction equalizing member (3) is formed on a plane different from the junction terminals (2) formed in the flexible substrate (1) or the junction terminals (6) formed in the opposing substrate (5).

12. The junction structure of the flexible substrate according to claim 11, **characterized in that** a thermal conductivity of the thermal conduction equalizing member (3) is higher than a thermal conductivity of a base material of the flexible substrate (1) or a base material of the opposing substrate (5).

13. The junction structure of the flexible substrate according to claim 12, **characterized in that** the thermal conduction equalizing member (3) has the width narrower than an interval between the junction terminals (2) formed in the flexible substrate (1) or an interval between the junction terminals (6) formed in the opposing substrate (5).

14. The junction structure of the flexible substrate according to claim 11, **characterized in that** the thermal conduction member (3) is made of the same material as the junction terminals (2) formed in the flexible substrate (1) or the junction terminals (6) formed in the opposing substrate (5).

15. The junction structure of the flexible substrate according to claim 14, **characterized in that** the thermal conduction equalizing member (3) has the width narrower than an interval between the junction terminals (2) formed in the flexible substrate (1) or an interval between the junction terminals (6) formed in the opposing substrate (5).

16. The junction structure of the flexible substrate according to claim 14, **characterized in that** the thermal conduction member (3) is made of the same material as the junction terminals (2) formed in the flexible substrate (1) or the junction terminals (6) formed in the opposing substrate (5).

17. The junction structure of the flexible substrate according to claim 1, **characterized in that** the flexible substrate (1) and opposing substrate (5) are joined in a state heated at the same temperature.
